# EUROPÄISCHE PATENTSCHRIFT

(11) **EP 0 960 219 B1**
(45) Veröffentlichungstag und Bekanntmachung des Hinweises auf die Patenterteilung: **19.06.2002**
(21) Anmeldenummer: 97949963.9
(22) Anmeldetag: 26.11.1997
(51) Int. Cl.: C23C 16/02, C23C 16/30, B22F 3/10, C04B 35/00, C04B 41/50

(54) **VERBUNDKÖRPER, BESTEHEND AUS EINEM HARTMETALL-, CERMET- ODER KERAMIKSUBSTRATKÖRPER UND VERFAHREN ZU SEINER HERSTELLUNG**
COMPOSITE BODY COMPRISING A HARD METAL, CERMET OR CERAMIC SUBSTRATE BODY AND METHOD OF PRODUCING THE SAME
CORPS COMPOSITE COMPOSE D'UN CORPS-SUBSTRAT EN METAL DUR, EN CERMET OU EN CERAMIQUE ET PROCEDE PERMETTANT DE LE PRODUIRE

(30) Priorität: 24.12.1996 DE 19654371; 30.05.1997 DE 19722728
(43) Veröffentlichungstag der Anmeldung: 01.12.1999
(73) Patentinhaber: Widia GmbH, 45145 Essen (DE)
(72) Erfinder: RÖDIGER, Klaus, D-44869 Bochum (DE); WESTPHAL, Hartmut, D-36466 Dermbach (DE); DREYER, Klaus, D-45138 Essen (DE); GERDES, Thorsten, D-44157 Dortmund (DE); WILLERT-PORADA, Monika, D-44289 Dortmund (DE)
(74) Vertreter: Vomberg, Friedhelm, Dipl.-Phys.
(86) Internationale Anmeldenummer: DE9702774
(87) Internationale Veröffentlichungsnummer: WO9828462

(56) Entgegenhaltungen:
- EP-A- 0 279 898
- WO-A-96/33830
- DE-A- 3 422 174
- US-A- 5 238 710

## Beschreibung

Die Erfindung betrifft ein Verfahren zur Herstellung von beschichteten Cermet-, Hartmetall- oder Keramiksubstratkörpern, bei dem aus einer Ausgangspulvermischung ein Grünling vorgepreßt, entwachst und anschließend in einem Mikrowellenfeld gesintert und mit einer Hartstoffbeschichtung bzw. einer Korrosionsschutz- oder Verschleißschutzbeschichtung aus einer oder mehreren Lagen überzogen wird.

Die Erfindung betrifft ferner einen Verbundkörper aus einem Substratkörper der genannten Art und mindestens einer Schicht aus einem Hartstoff.

Verbundwerkstoffe der genannten Art werden insbesondere als Schneidplatten zur zerspanenden Bearbeitung oder als Hochtemperaturwerkstoffe eingesetzt. Betreffende Verbundwerkstoffe werden in der Regel nach dem Stand der Technik durch Sintern von Presskörpern, die aus den entsprechenden Gemischen von Hartstoffen und Metallpulvern (Bindern) bestehen, hergestellt. Die Sinterung erfolgt in öfen, die beispielsweise mit Graphitheizelementen ausgerüstet sind, wobei die Erwärmung der Proben indirekt mittels der von den Heizelementen emitierten Strahlung sowie durch Konvektion bzw. Wärmeleitung erfolgt. Der Nachteil dieser Verfahrenstechnik liegt darin, daß die Wahl der Ofenatmosphäre durch die chemischen Eigenschaften der Heizelemente stark eingeschränkt ist. Darüber hinaus erfolgt die Erwärmung der Hartmetalle, Cermets oder Keramiken von außen nach innen und wird im wesentlichen durch die Wärmeleitfähigkeit und die Emissivität der Proben kontrolliert. Je nach Wärmeleitfähigkeit der Proben ist die Variationsbreite der Aufheiz- und Abkühlraten stark eingeschränkt, weshalb zum Teil aufwendige Maßnahmen, wie ein hoher apparativer und prozeßtechnischer Aufwand erforderlich sind, um beispielsweise Ultrafein-Hartmetalle zufriedenstellend sintern zu können.

Zur Beseitigung dieses Nachteils wird in der WO 96/33830 vorgeschlagen, vorgepreßte Grünlinge aus einem Cermet oder einem Hartmetall in einem Mikrowellenfeld zu sintern. Der vorgepreßte Grünling kann hierbei bereits während des Aufheizens kontinuierlich oder gepulst mit Mikrowellen bestrahlt werden, wobei während der Aufheizung Plastifizierer, wie Wachs, ausgetrieben werden.

Gegebenenfalls kann der fertig gesinterte Körper anschließend noch mittels PVD, CVD und/oder einer plasmaaktivierten CVD mit einer oder mehreren Hartstofflagen beschichtet werden.

Geeignete Mikrowellen-Sinteröfen und Sinter-Verfahren mittels Mikrowellenstrahlung werden beispielsweise in der DE 195 15 342 beschrieben.

Neben der Wahl des Materials für die Substratbeschichtung, bei der insbesondere Karbide, Nitride und/oder Karbonitride der Elemente der IVa- bis VIa-Gruppe, diamantähnliche Stoffe, keramische Stoffe wie Al₂O₃ und/oder ZrO₂ sowie Bornitrid in Frage kommen, ist die Haftung der Beschichtung auf dem Sinterkörper als Substratkörper von entscheidender Bedeutung.

Es ist Aufgabe der vorliegenden Erfindung, ein Verfahren sowie einen beschichteten Substratkörper der eingangs genannten Art anzugeben, bei dem gezielt die Haftung der einzigen oder ersten Schicht auf dem substratkörper verbessert werden kann. Das Verfahren soll ohne großen technischen Aufwand leicht handhabbar und energiesparend durchführbar sein.

Diese Aufgabe wird durch das Verfahren nach Anspruch 1 gelöst, das erfindungsgemäß dadurch gekennzeichnet ist, daß nach dem Entwachsen des Grünlings bei noch offener Porosität bei Temperaturen zwischen 600°C und 1100°C, vorzugsweise zwischen 800°C und 1100°C, der Grünling mit für die Hartstoffbeschichtung notwendigen Reaktionsgasen und/oder sublimierbaren Feststoffen beaufschlagt wird, dann die Temperatur des Grünlings weiter erhöht und dieser durch Sintern vollständig verdichtet wird, wonach abschließend eine oder mehrere Schichten aus Hartstoff, Keramik, diamantähnliche Schichten, Bornitrid oder ähnliches aufgetragen werden. Der Kerngedanke der Erfindung besteht darin, daß bei noch nicht geschlossenen äußeren Poren die Substratkörperoberfläche relativ rauh ist. Wird nun in dieser Phase bereits mit der CVI (chemical vapour infiltration), CVDoder PCVD-Beschichtung begonnen, kann das Beschichtungsmaterial die vorhandenen offenen Poren teilweise auffüllen, so daß sich beim Fertigsintern ein inniger Verbund des Beschichtungsmaterials mit dem Substratkörpermaterial ergibt, der zudem einen Gradienten-Übergang vom Substratwerkstoff zum Schichtwerkstoff ermöglicht. Die gewünschte erste oder einzige Schicht braucht während der Aufheizphase nicht bis zur gewünschten Dicke aufgetragen werden, es reicht bereits aus, wenn die Substratoberfläche mit dem betreffenden Beschichtungsmaterial dünnlagig benetzt wird. Im Unterschied zum konventionellen Sintern in einem mit Heizelementen beheizten Ofen, in dem die Sinterkörper von außen nach innen erwärmt werden, durchdringt die Mikrowellenstrahlung den Substratkörper bereits bei geringen Temperaturen. Da in einem Mikrowellenfeld befindliche Substratkörper bzw. die daraus gebildete Charge heißer sind als die Cavität, ist der bzw. sind die Substratkörper im Inneren wärmer als außen; in entsprechender Weise läuft der Sinterprozeß von innen nach außen ab. Die in der Aufheizphase aufgetragene Schicht oder Schichten, falls die Gasphasenzusammensetzung geändert wird, beeinflussen oder stören somit den Sinterprozeß nicht. Insgesamt kann das Sintern und Beschichten auch in dem Maße verkürzt werden wie bereits in der Aufwärmphase eine erste Beschichtung auf dem Substratkörper abgeschieden worden ist, auf der dann nach dem Fertigsintern ggf. weitere Schichten nach vorheriger Abkühlung auf übliche CVD-, Plasma-CVD-Temperatur "in einer Hitze" aufgetragen werden können.

Weiterbildungen des erfindungsgemäßen Verfahrens sind in den Unteransprüchen beschrieben.

Bei Hartmetallen wird vorzugsweise mit dem Einlassen der Gase, die zur reaktiven Abscheidung der genannten Stoffe erforderlich sind, dann begonnen, wenn der Volumenanteil der offenen Poren am Gesamtvolumen des Hartmetallgrundkörpers > 10 %, vorzugsweise 35 bis 60 % beträgt.

Für Keramiken und Cermets gilt hinsichtlich der offenen Poren Entsprechendes, vorzugsweise sollen bei Keramiken 35 bis 70 % bzw. 50 bis 60 % und bei Cermets 35 bis 60 %, vorzugsweise 40 bis 60 % bereichsweise eingehalten werden.

Je nach gewünschter Eindringtiefe der Infiltration kann es insbesondere bei Keramiken vorteilhaft sein, zunächst den Grünling bei höheren Temperaturen vorzuverdichten, bevor nach erfolgter Abkühlung auf 600°C bis 1100°C der Grünling mit für die Hartstoffbeschichtung notwendigen Reaktionsgasen und/oder sublimierbaren Feststoffen beaufschlagt wird. Alternativ hierzu kann, insbesondere bei Hartmetallen und Cermets die genannte Beaufschlagung während des Erwärmens des Grünlings nach dem Entwachsen (Entbindern) erfolgen.

Vorzugsweise wird bereits mit dem Beginn des Beaufschlagens mit Reaktionsgasen und/oder sublimierbaren Feststoffen (unter Verwendung von Trägergasen (Argon etc.) die Temperatur über einen Zeitraum von bis zu einer Stunde konstant gehalten oder die Aufheizgeschwindigkeit zu maximal 200°C/h bis zum Erreichen von mindestens 1000 bis 1100°C verlangsamt. Diese Maßnahme dient dazu, in einem für die CVI bzw. CVD-Abscheidung geeigneten Temperaturintervall genügend Zeit zur Abscheidung einer ersten dünnlagigen Schicht zu geben. Wie bereits erwähnt, werden die weiteren Schichten aus Hartstoff, Keramik, Diamant, Bornitrid oder ähnlichen Stoffen unmittelbar in der Abkühlphase mittels CVD oder PCVD aufgetragen.

Für die abschließende CVD/PCVD-Beschichtung kommt ein wesentlicher Vorteil des Mikrowellensinterns zum Tragen, nämlich die Möglichkeit bis hin zu hohen Dichten einen Teil der Porosität offen zu halten. Damit ist eine gute Verankerung der in der Abkühlphase bei Gesamtporositäten von < 10 % aufgetragenen CVD/PVD-Schichten gewährleistet. Die Vorbehandlung der Oberflächen, wie sie bei konventioneller CVD/PCVD häufig erforderlich ist, entfällt.

Das erfindungsgemäße Verfahren ermöglicht darüber hinaus, durch eine gezielte Einstellung des (Partial-)Druckes und der Temperaturwahl, die Auffüllung der randnahen Poren des Substratkörpers mit den aus den Reaktionsgasen und/oder sublimierbaren Feststoffen gebildeten Stoffen (Beschichtungsmaterial), wobei im Substratkörper von außen nach innen bis zu einer maximalen Eindringtiefe von 200 µm ein nach innen abnehmender Gradient dieser Stoffe entsteht. Anders als bei der nach dem Stand Technik grundsätzlich bekannten vollständigen Infiltration von Keramikwerkstoffen durch aus der Gasphase kommenden oder entstehenden Verbindungen, die sich im wesentlichen homogen über den infiltrierten Körper erstrecken, werden mit dem erfindungsgemäßen Verfahren nur die randnahen, während der Aufheizphase noch nicht verschlossenen Poren in nach innen abnehmendem Maße durch die sich aus der Gasphase bildenden Stoffe aufgefüllt, bevor der Substratkörper während des Sinterns abschließend verdichtet wird.

Je nach Chargengröße liegt die vorzugsweise verwendete Mikrowellenleistung zwischen 10 W bis 100 kW. Der eingestellte Druck während der genannten Aufheizphase, der aus an der Reaktionsabscheidung beteiligten Gasen, Trägergasen und sonstigen Prozeßbegleitern gebildet wird, liegt bei der Abscheidung während der Aufheizphase zwischen 0,1 kPa und 100 kPa. Je nach Druck kann die Eindringtiefe des Beschichtungsmaterials in randnahe Poren des substratkörpers variiert werden. Als Reaktionsgase kann auf alle im Rahmen von CVI- und CVD-AbScheidungen bekannte Gase zurückgegriffen werden, insbesondere auf Metallhalogenide, Methan, Stickstoff, Gase mit Cyanid-Anteil, bei denen zwischen Kohlenstoff und Stickstoff eine Dreifachbindung besteht, wie beispielsweise beim Acetonitril, Alkoholate, β-Diketonate und Carbonate. In Frage kommen aber auch molekulare Prekursoren, die Elemente zur gewünschten Reaktionsabscheidung oder Porenauffüllung liefern, wozu insbesondere metallorganische Verbindungen gehören.

Bevorzugte Werkstoffe, die auf dem Substratkörper in einer oder mehreren Lagen abgeschieden werden, sind insbesondere Karbide, Nitride oder Karbonitride der Metalle der Iva bis VIa-Gruppe des Periodensystems, Al₂O₃, ZrO₂, Kohlenstoff als diamantähnliche Schicht, amorpher Kohlenstoff und/oder kubisches bzw. hexagonales Bornitrid.

Nach einer weiteren Ausbildung der Erfindung ist es möglich, auf keramischen Substratkörpern aus Al₂O₃ eine keramische Schicht mit infiltriertem ZrO₂ und/oder eine oder mehrere weitere Lagen, insbesondere TiC abzuscheiden. In entsprechender Weise können jedoch auch ein- oder mehrphasige Schichtlagen, die aus Hartstoffen, Cermet, Keramiken und/oder Metallen gebildet werden, unmittelbar auf den Substratkörper als Zwischenlage oder als äußere Schicht aufgetragen werden.

Wird während der Aufheizphase eine erste dünnlagige Schicht von 0,1 µm bis 10 µm, vorzugsweise 1 µm aufgetragen, so wird nach einer bevorzugten Weiterentwicklung der Erfindung nach dem Fertigsintern des dünnlagig beschichteten Substratkörpers durch entsprechendes Einlassen derselben Reaktionsgase wie in der Aufheizphase die "angefangene" Beschichtung bis zum Erreichen der gewünschten Dicke dieser einzigen oder ersten Schicht fortgesetzt.

Die Erfindung betrifft ferner den im Anspruch 10 beschriebenen Verbundkörper, der aus einem Hartmetall-Cermet, oder Keramiksubstratkörper und mindestens einer Schicht aus einem Hartstoff, einem Keramikstoff, einer Diamantschicht, amorphem Kohlenstoff und/oder Bornitrid besteht und der erfindungsgemäß dadurch gekennzeichnet ist, daß in der an die Beschichtung angrenzenden Zone des Substratkörpers mit nach innen abnehmen dem Gradienten im Substratkörper Hartstoffe der selben Art wie die erste Hartstoffschicht eingelagert sind, vorzugsweise bis zu einer Eindringtiefe von maximal 200 µm und/oder die Grenze zwischen der Substratkörperoberfläche und der ersten Schicht eine Rauhigkeit aufweist, die etwa der Oberflächenrauhigkeit eines teilverdichteten Grünlings mit einer offenen Porosität bei 600°C bis 800°C vor dem Sintern entspricht. Hinsichtlich der Vorteile dieses Verbundkörpers und der speziellen Ausführungsformen gilt entsprechendes wie oben ausgeführt.

In einem konkreten Ausführungsbeispiel sind sechs Wendeschneidplatten bei Normaldruck beschichtet und gesintert worden.

Die paraffinierten WC-CO-Grünkörper (Kobaltgehalt 6 Massen-%) werden in einem ersten Teilschritt im 2,45 Ghz Multi-Moden-Applikator unter Ar-Atmosphäre bei geringer Mikrowellenleistung von weniger als 250 W ca. 20 Minuten entwachst, wobei die Grünlinge zur thermischen Isolierung in einer Isolierbox aus mikrowellen-transparenten Al₂O₃-Faserplatten angeordnet sind. Nach dem Entwachsen werden die Grünkörper weiter auf 850°C aufgeheizt. Bei dieser Temperatur wird aus der Gasphase ein TiC-Prekursor 20 Minuten lang auf den Proben abgeschieden. Die Proben haben bei dieser Temperatur eine offene Porosität von 45 % der theoretischen Dichte. Als TiC-Prekursor dient Titan(Diisopropoxid)BiS(Pentandionat) (TDP). Die Beladung der Atmosphäre mit TDP erfolgt mit Hilfe eines Argonstroms von 1 l/min, der durch eine auf 100°C vorgewärmten TDP-Vorlage geleitet wird. Der mit TDP beladene Gasstrom wird durch Keramikröhrchen direkt in die Mikrowellen-transparente Isolierbox geleitet. In dieser ersten Beschichtungsstufe, bei der die Temperatur von 850°C gehalten wird, werden in den randnahen Zonen, die durch die offene Porosität zugänglichen inneren Oberflächen nur partiell beschichtet, während die Randzone vollständig beschichtet wird. Nach Beendigung der Haltezeit wird der Grünkörper durch Erhöhung der Mikrowellenleistung in 30 Minuten auf die Sintertemperatur von 1400°C erwärmt. die Sintertemperatur wird 15 Minuten gehalten, wonach die vollständig verdichteten Sinterkörper (Wendeschneidplatten) auf 850°C abgekühlt und bei dieser Temperatur erneut 20 Minuten unter den oben beschriebenen Bedingungen mit TiC beschichtet werden.

In einem weiteren Ausführungsbeispiel werden sechs Wendeschneidplatten derselben Zusammensetzung wie oben beschrieben in Mikrowellenplasma beschichtet und gesintert. Im Unterschied zum vorbeschriebenen Verfahren wird nach Erreichen von 850°C in der Aufwärmphase mit der Einleitung des Ar-TDP-Gemisches begonnen und zugleich der Druck so weit abgesenkt, daß innerhalb der Isolierbox bei der gegebenen Mikrowellenfeldstärke Plasmabedingungen erreicht werden. Der eingestellte Druck liegt zwischen 5 kPa und 30 kPa in dem eingestellten Mikrowellenplasma wird die Beschichtung 20 Minuten durchgeführt und anschließend der Druck wieder auf 100 kPa erhöht, um die Wendeschneidplatten wie im ersten Ausführungsbeispiel beschrieben, im Mikrowellenfeld zu sintern. In der Abkühlphase wird bei 850°C erneut der Druck unter Einleitung des Ar-TDP-Gemisches bis zum Erreichen der Plasmabedingungen abgesenkt, um in 20 Minuten eine geschlossene TiC-Schicht aufzubringen.

In einem dritten Ausführungsbeispiel wurde wie nach den ersten beiden geschilderten Varianten verfahren, zusätzlich sind durch Wechsel der Gasatmosphäre bzw. des Prekursors auf der ersten TiC-Schicht eine oder merhere weitere Schichten aufgetragen, nämlich als zweite Schicht TiCN oder TiN bzw. die Schichtfolge TiCN und TiN. Alternativ hierzu ist als zweite Schicht ein Karbid und/oder Nitrid des Zr sowie ZrO₂, Al₂O₃ bzw. Kombinationen hieraus abgeschieden worden.

Bei einem weiteren Ausführungsbeispiel wurden Al₂O₃-Grünkörper in einem ersten Teilschritt in einem 2,45 GHz Multi-Moden-Applikator unter Normaldruck bei geringer MW-Leistung von 300 W ca. 30 min entbindert. Zur thermischen Isolierung wurden die Grünlinge in einer Isolierbox aus MW-transparenten Al₂O₃-Faserplatten angeordnet. Nach den Entbindern wurden die Grünkörper auf 800°C aufgeheizt. Bei dieser Temperatur wird aus der Gasphase ein ZrO₂-Prekursor 30 min lang auf den Proben abgeschieden. Als Prekursor dient Zirkontetrapropylat (ZTP). Die Beladung der Atmosphäre mit ZTP erfolgt mit Hilfe eines Argonstromes von 1 l/min, der durch eine auf ca. 200°C vorgewärmten ZTP-Vorlage geleitet wird. Der mit ZTP beladene Gasstrom wird durch Keramikröhrchen direkt in die MW-transparente Isolierbox geleitet. Nach Beendigung der Beschichtung werden die Grünkörper durch Erhöhung der MW-Leistung in 50 min auf die Sintertemperatur von 1600°C erwärmt. Nach einer Haltezeit von 30 min werden die verdichteten Al₂O₃-Körper abgekühlt.

In der vorbeschriebenen Anordnung wurden in einem weiteren Ausführungsbeispiel die Al₂O₃-Grünkörper zunächst entbindert und in 90 min auf eine Sintertemperatur von 1400°C aufgeheizt. Nach einer Haltezeit von 20 min werden die noch nicht vollständig verdichteten Körper auf 800°C abgekühlt und in der zuvor beschriebenen Weise 30 min mit ZrO₂ beschichtet. Nach dieser auf den oberflächennahen Bereich beschränkten Beschichtung werden die Proben auf 1600°C aufgeheizt und nach einer Haltezeit von 30 min wieder auf Raumtemperatur abgekühlt.

## Patentansprüche

1. Verfahren zur Herstellung von beschichteten Cermet-, Hartmetall- oder Keramiksubstratkörpern, bei dem aus einer Ausgangspulvermischung ein Grünling vorgepreßt, entwachst und anschließend in einem Mikrowellenfeld gesintert und mit einer Beschichtung aus einer oder mehreren Lagen überzogen wird,
**dadurch gekennzeichnet,**
**daß** nach Entwachsen des Grünlings bei noch offener Porosität bei Temperaturen zwischen 600°C und 1100°C, vorzugsweise zwischen 800°C und 1100°C, der Grünling mit für die Beschichtung notwendigen Reaktionsgasen und/oder sublimierbaren Feststoffen beaufschlagt wird, dann die Temperatur des Grünlings weiter erhöht und dieser durch Sintern vollständig verdichtet wird und anschließend eine oder weitere Schichten aus Hartstoffen, Keramik, diamantähnliche Schichten, hexagonalem Bornitrid und/oder amorphem Kohlenstoff aufgetragen werden.

2. Verfahren nach Anspruch 1, **dadurch gekennzeichnet, daß** der Grünling erst dann mit Reaktionsgasen und/oder sublimierbaren Feststoffen beaufschlagt wird, wenn der Volumenanteil der offenen Poren am Gesamtvolumen des Substrat-körpers > 10 %, vorzugsweise 40 bis 60 % der theoretischen Dichte (bei Hartmetallen) oder > 10 %, vorzugsweise 35 bis 70 % oder 50 bis 60 % (bei Keramiken) oder > 10 %, vorzugsweise 35 bis 60 % oder 40 bis 60 % (bei Cermets) beträgt.

3. Verfahren nach Anspruch 1 oder 2, **dadurch gekennzeichnet, daß** mit dem Beginn des Beaufschlagens mit Reaktionsgasen und/oder sublimierbaren Feststoffen die Temperatur über einen Zeitraum von bis zu einer Stunde konstant gehalten oder die Aufheizgeschwindigkeit zu maximal 200°C/h bis zum Erreichen von mindestens 1000 bis 1100°C verlangsamt wird.

4. Verfahren nach einem.der Ansprüche 1 bis 3, **dadurch gekennzeichnet, daß** nach Entwachsen des Grünlings bei noch offener Porosität während des weiteren Erwärmens des Grünlings ab einer Temperatur, die zwischen 600°C und 1100°C, vorzugsweise zwischen 800°C und 1100°C liegt, der Grünling mit für die Beschichtung notwendigen Reaktionsgasen und/oder sublimierbaren Feststoffen beaufschlagt wird, dann die Temperatur des Grünlings weiter erhöht und dieser durch Sintern vollständig verdichtet wird und anschließend eine oder weitere Schichten aus Hartstoffen, Keramik, diamantähnliche Schichten, hexagonalem Bornitrid und/oder amorphem Kohlenstoff aufgetragen werden, vorzugsweise unmittelbar in der Abkühlphase mittels CVD oder PCVD.

5. Verfahren nach Anspruch 1 oder 2, **dadurch gekennzeichnet, daß** der Grünling, insbesondere der Keramik-Grünling, zunächst bei einer höheren Temperatur vorverdichtet, anschließend auf eine Temperatur zwischen 600°C bis 1100°C, vorzugsweise zwischen 800°C und 1100°C abgekühlt und dann mit für die Beschichtung notwendigen Reaktionsgasen und/oder sublimierbaren Feststoffen beaufschlagt wird, bevor die Temperatur des Grünlings weiter erhöht und dieser durch Sintern vollständig verdichtet wird und abschließend eine oder weitere Schichten aus Hartstoffen, Keramik, diamantähnliche Schichten, hexagonalem Bornitrid und/oder amorphem Kohlenstoff aufgetragen werden, wobei vorzugsweise die weiteren Schichten aus Hartstoffen, Keramik, Diamant, hexagonalem Bornitrid oder amorphem Kohlenstoff unmittelbar in der Abkühlphase mittels CVD oder PCVD aufgetragen werden.

6. Verfahren nach einem der Ansprüche 1 bis 5, **dadurch gekennzeichnet, daß** durch gezielte Einstellung eines (Partial)Druckes und Temperaturwahl die randnahen Poren des Substratkörpers mit aus den Reaktionsgasen und/oder sublimierbaren Feststoffen gebildeten Stoffen aufgefüllt werden, wobei im Substratkörper von außen nach Innen bis zu einer maximalen Eindringtiefe von 200 µm ein nach innen abnehmender Gradient dieser Stoffe entsteht.

7. Verfahren nach einem der Ansprüche 1 bis 6, **dadurch gekennzeichnet, daß** eine Mikrowellen-Leistung zwischen 10 W bis 100 kW eingestellt wird und/oder daß der eingestellte Druck aus Reaktionsgasen und Trägergasen nach Erreichen der Temperatur von mindestens 600°C, vorzugsweise 800°C, zwischen 0,1 kPa und 100 kPa liegt.

8. Verfahren nach einem der Ansprüche 1 bis 7, **dadurch gekennzeichnet, daß** als Reaktionsgase Metallhalogenide, Methan, Stickstoff, Gase mit C-N-Gruppen (Cyaniden), insbesondere Acetonitril, Alkoholate, β-Diketonate, Carbonate oder molekulare Prekursoren, die Elemente zur gewünschten Reaktionsabscheidung oder Porenauffüllung liefern, insbesondere metallorganische Verbindungen, verwendet werden und daß auf dem Substratkörper Karbide, Nitride oder Karbonitride der Metalle der IVa bis VIa-Gruppe des Periodensytems, Al₂O₃, ZrO₂, Kohlenstoff als diamantähnliche Schicht, amorpher Kohlenstoff und/oder hexagonales Bornitrid abgeschieden werden.

9. Verfahren nach einem der Ansprüche 1 bis 8, **dadurch gekennzeichnet, daß** auf dem Substratkörper aus Al₂O₃ eine Schicht mit infiltriertem ZrO₂ und/oder eine oder mehrere weitere Lagen, insbesondere TiC abgeschieden werden ünd/oder daß während der Aufheiz- oder Haltephase zwischen 600°C und 1100°C nur eine dünnlagige erste Schicht von maximal 1 µm aufgetragen, dieser dünnlagig beschichtete Substratkörper dann fertig gesintert und anschließend in der Abkühlphase der Schichtauftrag der dünnlagigen Schicht mit dem selben Schichtwerkstoff bis zur gewünschten Dicke dieser einzigen oder ersten Schicht fortgesetzt wird.

10. Verbundkörper, bestehend aus einem Hartmetall-, Cermetoder Keramiksubstratkörper und mindestens einer Schicht aus einem Hartstoff, einem Keramikstoff, einer diamantähnlichen Schicht, amorphem Kohlenstoff und/oder hexagonalem Bornitrid, **dadurch gekennzeichnet, daß** in der an die Beschichtung angrenzenden Zone des Substratkörpers mit nach innen abnehmendem Gradienten im Substratkörper Stoffe derselben Art wie die erste Schicht eingelagert sind, vorzugsweise bis zu einer Eindringtiefe von maximal 200 µm und/oder daß die Grenzfläche zwischen der Substratkörperoberfläche und der ersten Schicht eine Rauhigkeit aufweist, die etwa der Oberflächenrauhigkeit eines teilverdichteten Grünlings mit einer offenen Porosität bei 600°C bis 800°C vor dem Sintern entspricht.

## Claims

1. Method for producing coated cermet-, hard metal- or ceramic substrate bodies, wherein a green compact is precompressed from an initial powder mixture, dewaxed and subsequently sintered in a microwave field and covered with a coating of one or more layers,
**characterized in that**,
after dewaxing of the green compact with still open porosity temperatures between 600°C and 1100°C, preferably between 800°C and 1100°C, the green compact is treated with the reaction gases and/or sublimable solid material necessary for the coating, then the temperature of the green compact is further increased and it is completely densified by sintering and subsequently one or further layers of hard material, ceramic, diamond-like layers, hexagonal boron nitrides and/or amorphous carbon are applied.

2. Method according to claim 1, **characterized in that** the green compact only then treated with reaction gases and/or sublimable solid materials when the volume-part of open pores in relation to the total volume of the substrate body is > 10 %, preferably 40 to 60 % of the theoretical density (in hard metals) or > 10 %, preferably 35 to 70 % or 50 to 60 % (in ceramics) or > 10 %, preferably 35 to 60 % or 40 to 60 % (in cermets).

3. Method according to claim 1 or 2, **characterized in that** with the start of the treatment with reaction gases and/or sublimable solid materials the temperature is kept constant over a period of up to one hour, or the heating speed is slowed down to maximum 200°C/h until at least 1000 to 1100°C are reached.

4. Method according to one of the claims 1 to 3, **characterized in that** after dewaxing of the green compact when the porosity is still open during the further heating of the green compact, starting from a temperature arranging between 600°C and 1100°C, preferably between 800°C and 1100°C, the green compact is treated with reaction gases and/or sublimable solid materials, necessary for coating, then the temperature of the green compact is further increased and it is completely densified by sintering and subsequently one or further layers of hard materials, ceramic, diamond-like layers, hexagonal boron nitride and/or amorphous carbon are applied, preferably directly during the cooling phase by CVD or PVD.

5. Method according to claim 1 or 2, **characterized in that** the green compact, in particular the ceramic green compact, is at first precompressed at a higher temperature, then cooled down to a temperature between 600°C and 1100°C, preferably between 800°C and 1100°C, and then treated with the reaction gases and/or sublimable solid materials necessary for coating, before the temperature of the green compact is raised again and it is fully densified by sintering and finally one or further layers of hard materials, ceramic, diamond-like layers, hexagonal boron nitrides and/or amorphous carbon are applied directly during the cooling phase by CVD or PCVD.

6. Method according to one of the claims 1 to 5, **characterized in that** through a controlled setting of a (partial) pressure and temperature selection the pores close to the margin of the substrate body are filled by the substances formed from the reaction gases and/or the sublimable solid materials, whereby in the substrate body from the outside to the inner, up to a maximal penetration depth of 200 µm, an inwards decreasing gradient of this substances results.

7. Method according to one of the claims 1 to 6, **characterized in that** a microwave power between 10 W to 100 kW is set and/or that the set pressure of the reaction gases and carrier gases ranges between 0,1 kPa and 100 kPa after reaching a temperature of at least 600°C, preferably 800°C.

8. Method according to one of the claims 1 to 7, **characterized in that** as reaction gases metal halogenides, methane, nitrogen, gases with C-N-groups (cyanides), in particular acetonitrile, alcoholates, β-diketonates, carbonates, or molecular precursors, which deliver elements for the desired reaction deposition or for filling in particular metallic-organic compounds are used, and that onto the substrate body carbides, nitrides or carbonitrides of the metals of groups IVa to VIa of the periodical system, Al₂O₃, ZrO₂, carbon as a diamond-like layer, amorphous carbon and/or hexagonal boron nitride are deposited.

9. Method according to one of the claims 1 to 8, **characterized in that** onto the substrate body of Al₂O₃ a layer with infiltrated ZrO₂ and/or one or more further layers, in particular TiC are deposited and/or that during the heating or dwelling faces between 600°C and 1100°C, only a thin layered first layer of maximum 1 µm is applied, this substrate body covered with a thin layer is then fully sintered and subsequently in the cooling phase the layer application of the thin layer is continued with the same layer material until the desired thickness of this sole or first layer is achieved.

10. Composite body, consisting of a hard metal-, cermet-, or ceramic-substrate body and at least one layer of a hard material, a ceramic material, a diamond-like layer, amorphous carbon and/or hexagonal boron nitride, **characterized in that** in the zone of the substrate body bordering the coating materials like the one of the first coating layer are embedded with an inwardly decreasing gradient, preferably up to a penetration depth of maximum 200 µm and/or that the border surface between the substrate body surface and the first layer has a roughness which corresponds approximately to the roughness of a partially densified green compact with an open porosity at 600°C and 800°C prior to sintering.

## Revendications

1. Procédé de fabrication de corps substrat revêtus en cermet, en métal dur ou en céramique, dans lequel un compact vert est précomprimé à partir d'un mélange initial de poudre, est déciré et est ensuite fritté dans un champ à micro-ondes et couvert d'un revêtement en une ou en plusieurs couches,
**caractérisé par le fait que**
après le décirage du compact vert avec une porosité encore ouverte à des températures comprises entre 600°C et 1100°C, de préférence entre 800°C et 1100°C, le compact vert est soumis à des gaz de réaction et/ou à des matières solides sublimables nécessaires au revêtement, qu'ensuite la température du compact vert est augmentée encore plus et ce-dernier est densifié complètement par frittage et que, ensuite, une ou d'autres couches en matières dures, en céramique, des couches diamantaires, des couches en nitrure de bore hexagonal et/ou en carbone amorphe sont appliquées.

2. Procédé selon la revendication 1, **caractérisé par le fait que** le compact vert n'est soumis à des gaz de réaction et/ou à des matières solides sublimables que lorsque la part de volume des pores ouverts au volume total du corps substrat est > 10 %, de préférence comprise entre 40 et 60 % de la densité théorique (dans le cas de métaux durs) ou > 10 %, de préférence comprise entre 35 et 70 % ou entre 50 et 60 % (dans le cas de céramiques) ou > 10 %, de préférence comprise entre 35 et 60 % ou entre 40 et 60 % (dans le cas de cermets).

3. Procédé selon la revendication 1 ou 2, **caractérisé par le fait que**, avec le moment où l'on commence à soumettre le compact vert à des gaz de réaction et/ou à des matières solides sublimables, la température est maintenue constante pendant une durée allant jusqu'à une heure, ou que la vitesse d'échauffement est ralentie de manière à passer au maximum à 200°C/h jusqu'à ce qu'une température d'au moins 1000 à 1100°C soit atteinte.

4. Procédé selon l'une des revendications 1 à 3, **caractérisé par le fait que**, après le décirage du compact vert lorsque la porosité est encore ouverte durant l'autre échauffement du compact vert à partir d'une température qui est comprise entre 600°C et 1100°C, de préférence entre 800°C et 1100°C, le compact vert est soumis à des gaz de réaction et/ou à des matières solides sublimables nécessaires au revêtement, qu'ensuite la température du compact vert est augmentée encore plus et ce-dernier est densifié complètement par frittage et que, ensuite, une ou d'autres couches en matières dures, en céramique, des couches diamantaires, des couches en nitrure de bore hexagonal et/ou en carbone amorphe sont appliquées, de préférence immédiatement dans la phase de refroidissement au moyen du CVD ou du PCVD.

5. Procédé selon la revendication 1 ou 2, **caractérisé par le fait que** le compact vert, en particulier le compact vert en céramique, est d'abord précomprimé à une température plus élevée, est refroidi ensuite à une température comprise entre 600°C et 1100°C, de préférence entre 800°C et 1100°C, et est soumis ensuite à des gaz de réaction et/ou à des matières solides sublimables nécessaires au revêtement, avant que la température du compact vert soit augmentée encore plus et ce-dernier soit densifié complètement par frittage, et que, finalement, une ou d'autres couches en matières dures, en céramique, des couches diamantaires, des couches en nitrures de bore hexagonal et/ou en carbone amorphe sont appliquées, de préférence les autres couches en matières dures, en céramique, en diamant, en nitrure de bore hexagonal ou en carbone amorphe étant appliquées immédiatement dans la phase de refroidissement au moyen du CVD ou du PCVD.

6. Procédé selon l'une des revendications 1 à 5, **caractérisé par le fait que**, en réglant de manière contrôlée une pression (partielle) et en choisissant la température, les pores du corps substrat qui sont situés près de la surface sont remplis de substances formées à partir des gaz de réaction et/ou des matières solides sublimables, un gradient de ces substances qui diminue vers l'intérieur étant crée dans le corps substrat de l'extérieur vers l'intérieur jusqu'à une profondeur maximale de pénétration de 200 µm.

7. Procédé selon l'une des revendications 1 à 6, **caractérisé par le fait que** l'on règle une puissance de micro-ondes qui est comprise entre 10 W et 100 kW et/ou que la pression réglée formée par les gaz de réaction et les gaz porteurs est comprise entre 0,1 kPa et 100 kPa après avoir atteint la température de 600°C au moins, de préférence de 800°C.

8. Procédé selon l'une des revendications 1 à 7, **caractérisé par le fait que** l'on utilise comme gaz de réaction des halogénures de métal, du méthane, de l'azote, des gaz avec des groupes C-N (cyanures), en particulier de l'acétonitrile, des alcoolats, des β-dicétonates, des carbonates ou des précurseurs moléculaires qui fournissent des éléments pour la déposition souhaitée de réaction ou pour le remplissage des pores, en particulier des composés organo-métalliques, et que des carbures, des nitrures ou des carbonitrures des métaux du groupe IVa à VIa de la classification périodique des éléments, de l'Al₂O₃, du ZrO₂, du carbone comme couche diamantaire, du carbone amorphe et/ou du nitrure de bore hexagonal sont déposés sur le corps substrat.

9. Procédé selon l'une des revendications 1 à 8, **caractérisé par le fait qu'**une couche avec du ZrO₂ infiltré et/ou une ou plusieurs autres couches, en particulier du TiC sont déposées sur le corps substrat en Al₂O₃, et/ou que, durant la phase d'échauffement ou de maintien entre 600°C et 1100°C, seulement une première couche mince de 1 µm au maximum est appliquée, que ce corps substrat revêtu d'une couche mince est ensuite complètement fritté et que, ensuite, dans la phase de refroidissement, la déposition de la couche mince est continuée avec le même matériau de couche jusqu'à ce que l'épaisseur souhaitée de cette couche unique ou première couche soit atteinte.

10. Corps composite se composant d'un corps substrat en métal dur, en cermet ou en céramique et d'au moins une couche en une matière dure, en une matière céramique, en une couche diamantaire, en carbone amorphe et/ou en nitrure de bore hexagonal, **caractérisé par le fait que**, dans la zone du corps substrat qui est contiguë au revêtement, des substances du même type que la première couche sont enrobées dans le corps substrat avec un gradient diminuant vers l'intérieur, de préférence jusqu'à une profondeur de pénétration de 200 µm au maximum, et/ou que la surface limite entre la surface du corps substrat et la première couche présente une rugosité qui correspond à peu près à la rugosité de surface d'un compact vert partiellement densifié avec une porosité ouverte à une température de 600°C à 800°C avant le frittage.
